# EUROPEAN PATENT APPLICATION

(11) **EP 0 807 854 A1**
(43) Date of publication of application: **19.11.1997**
(21) Application number: 97401061.3
(22) Date of filing: 13.05.1997
(51) Int. Cl.: G03F 9/00

(54) **Exposure method and apparatus**

(30) Priority: 15.05.1996 JP 120299/96
(71) Applicant: Nikon Corporation, Tokyo 140 (JP)
(72) Inventor: Nei, Masahiro, c/o Nikon Corporation I.P.H., Chiyoda-ku, Tokyo (JP)
(74) Representative: Dubois-Chabert, Guy

(57) **Abstract**

Wafer mark positions of a plurality of sample shots selected from each of the shot regions are detected using the FIA alignment sensor (13) in the EGA alignment method. Scaling factors and the matrix coordinates for each of the shot regions are calculated based on measurement results. The projection magnification rate of the projection optical system (PL) is adjusted based on the scaling factors. Each of the shot regions are shifted to an exposure position based on the matrix coordinates detected from signals from wafer marks (12) using the TTR alignment sensor. When the intensity of the signal is equal to or less than the predetermined value, the region is aligned based on the matrix coordinates in the EGA method and is exposed.

## Description

### BACKGROUND OF THE INVENTION

The present invention relates to an exposure method and apparatus which is used in photolithographic processing in manufacturing, for example, semiconductor devices, image pick-up devices (e.g., CCD), liquid crystal display devices, or thin film magnetic heads. More particularly, the present invention relates to an exposure method and apparatus in which a mask pattern is exposed onto a substrate such as a wafer. It is particularly suitable for the die-by-die exposure method in which TTR (through-the-reticle) alignment sensor aligns the mask and pattern.

Typically, semiconductor devices such as large-scale integration (LSI) devices, etc., are formed such that circuit patterns are multi-layered in a predetermined positional relationship. Therefore, the projection exposure apparatus (stepper, etc.) which prints the reticle pattern from a mask onto each of the shot regions on a wafer must be capable of highly accurately aligning the circuit pattern which has been formed in each of the shot regions with the reticle pattern to be exposed.

Alignment sensors which serve this purpose include the laser-step alignment (LSA) type, in which a laser beam is emitted onto dotted alignment marks to cause diffraction or scattering to measure the position of the alignment marks. Another type is the field-image alignment (FIA) type, in which exposure light of a wide bandwidth from a halogen lamp light source is irradiated onto the alignment marks to produce an image of an alignment mark and measurements are taken by analyzing the image data.

A further type is the laser-interferometric alignment (LIA) type in which two laser beams with the same or slightly different frequencies are emitted from two different directions onto the alignment marks which look like diffraction gratings on the wafer to generate interference between two deflected beams such that measurements are taken by the phase difference between the two beams.

Conventional alignment methods include the following:
the through-the-lens (TTL) method, in which the wafer position is measured through a projection optical system;
the off-axial method, in which the wafer position is detected directly, without passing through the projection optical system; and
the through-the-reticle (TTR) method in which a wafer and a reticle are observed simultaneously through a projection optical system to obtain the target value (baseline) for the relative positional relationship between the wafer and the reticle. Particularly, the die-by-die alignment method in which the TTR alignment sensor repeats alignment and exposure for each of the shot regions, provides highly accurate alignment. Note that the TTL alignment, in which the TTL alignment sensor, which repeats alignment and exposure for each of the shot regions, is sometimes called the site-by-site alignment because different positions are given for alignment and exposure for the sensor which repeats alignment and exposure for each of the shot regions. The die-by-die method described in this specification includes such a site-by-site method. In other words; alignment is performed for each of the shot regions.

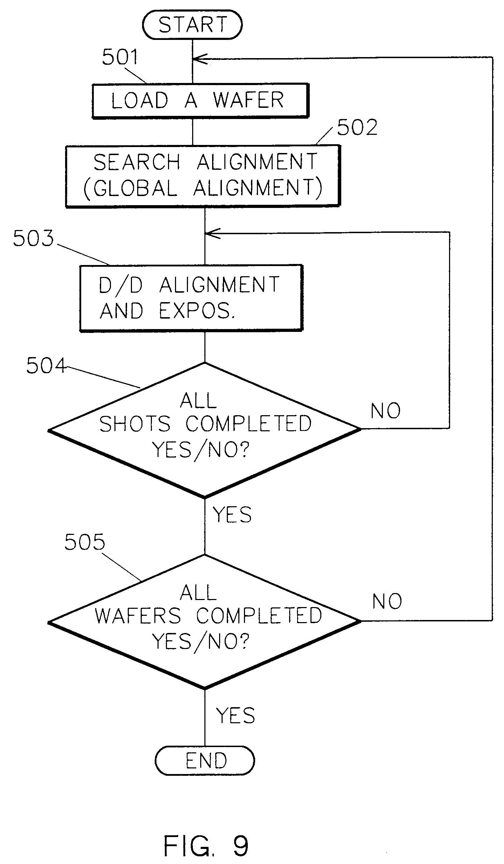

Figure 9 shows a flowchart in which the conventional TTR alignment sensor aligns and exposes in the die-by-die method. As shown in Figure 9, in step 501, a wafer is loaded on a wafer stage; in step 502, positions of the search alignment marks on the wafer are measured to perform a search alignment using another alignment sensor. Rough matrix coordinates in the wafer stage coordinate system are calculated for each of the shot regions based on the conversion parameters obtained in the search alignment step and the design coordinates which are given for each of the shot regions to perform a so-called global alignment.

Next, in step 503, the wafer stage is moved based on the rough matrix coordinates obtained for each of the shot regions. Then, in the die-by-die method, the TTR alignment sensor measures the deviation of the wafer marks formed in each of the shot regions on a wafer from the reticle marks formed on the reticle. Based on the results, the wafer marks and the reticle marks are aligned and exposed.

In step 504, whether or not all the shot regions are exposed is checked. When completed, the sequence goes to step 505. If any shot regions are not yet exposed, the sequence goes back to step 503 again to repeat until all the shot regions are exposed. Next, in step 505, whether or not all the wafers are exposed is checked; steps 501 through 505 are repeated until all the wafers are exposed.

In the die-by-die alignment (hereafter referred to as D/D alignment) and exposure using a TTR alignment sensor, excellent alignment precision can be obtained even if some nonlinear expansion exists within a wafer because alignment is performed within the exposure position for each shot region. Therefore, in the D/D alignment using a conventional TTR alignment sensor, the exposure position is determined based on the positional data only on wafer marks formed in each of the shot regions on a wafer.

During exposure, it is necessary to control precisely the imaging factors of the projection optical system. In normal cases, a so-called "lens controller" which is built in a projection exposure apparatus controls environmental temperature, atmospheric pressure, and the fluctuation of imaging properties generated in the projection optical system due to exposing energy. On the other hand, a wafer may be distorted or expanded in each of its shot regions formed on a wafer or the wafer itself may be distorted during various process steps. Even so, in the D/D alignment using a conventional TTR alignment sensor, the imaging properties of the projection optical system are adjusted regardless of the expansion state of a wafer.

In the D/D alignment using the aforementioned conventional TTR alignment sensor, it is a prerequisite that alignment data be obtained for each of the shot regions on a wafer or unfavorable results may be observed. If there are some shot regions in which any damaged wafer marks provide insufficient positional data for the wafer marks or if there are some wafer marks missing in the shot regions around peripheries of a wafer, it is impossible to determine the coordinate positions for the wafer marks.

When the wafer itself is expanded or some chip patterns in shot regions are expanded, the center position of each of the shot regions may be correctly aligned to the center of the pattern image (exposure center) but the fluctuation of the magnification component generated due to the expansion of each of the shot regions is not correctable.

In addition, in the TTR alignment sensor configuration, the scaling of the regional pattern formed on the reticle cannot be detected. This causes alignment error when the original pattern is extended. In the same manner, in the die-by-die (side-by-side) method using the TTL alignment sensor, for example, missing wafer marks could make alignment difficult.

### SUMMARY OF THE INVENTION

It is accordingly an object of the present invention to provide an exposure method and apparatus which overcomes the problems of the prior art systems.

To solve these problems, the method and apparatus incorporating the principles of the present invention provides highly accurate alignment. Moreover, the method and apparatus incorporating the principles of the present invention even provides highly accurate alignment for the shot regions in which it is impossible to detect wafer mark positions on a wafer accurately.

It is a further object of the present invention to provide an exposure method and apparatus in which alignment precision can be improved by accurately detecting the scaling state of a wafer or a reticle during exposure in the die-by-die method using an alignment sensor.

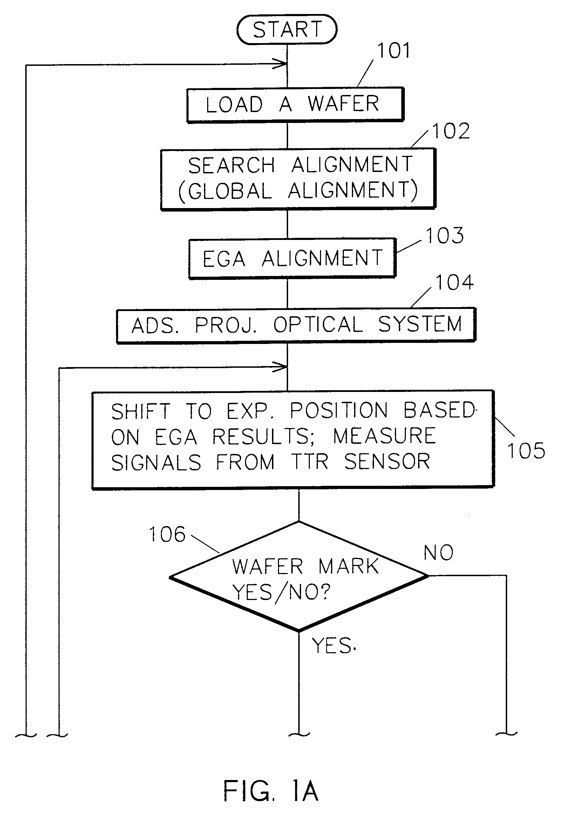

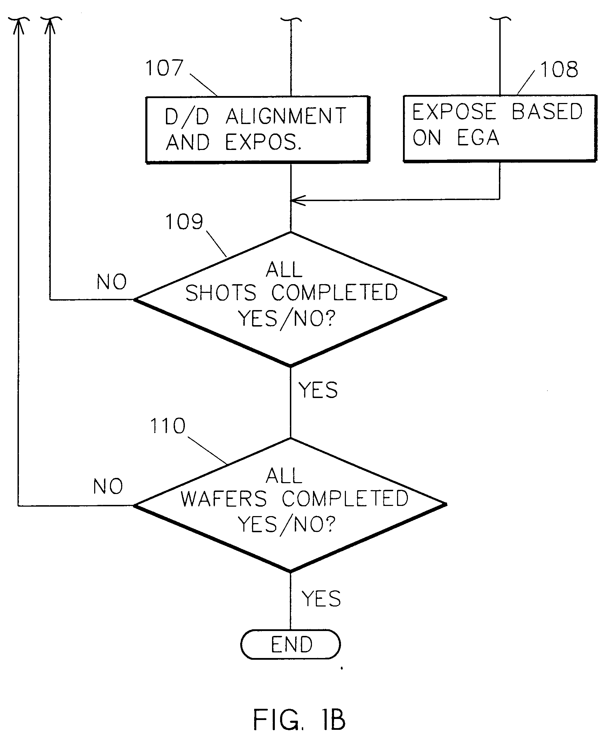

The first exposure method incorporating the principles of the present invention is shown in Figures 1 through 3. A pattern to be transferred, formed on a mask (R), is sequentially superimposingly photoprinted onto a plurality of shot regions on a photosensitive substrate (W) via a projection optical system (PL). The alignment of the mask (R) and each of the shot regions on the substrate (W) are performed via the die-by-die method using:
a first alignment sensor (8XA) which detects the relative deviation of alignment marks (12XA) formed in each of the shot regions of the substrate (W) from fiducial positions;
a second alignment sensor (13) which detects positions of global alignment marks (12XA; 14Y, 15Y, 15X) which define the matrix for each of the shot regions on the substrate (W); and
when aligning the mask (R) and each of the shot regions on the substrate (W), alignment is performed (steps 106 through 108) using the measurement taken by the first alignment sensor (8XA) and the matrix obtained by statistically analyzing the measurements taken by the second alignment sensor (13) together.

According to the first exposure method and apparatus incorporating the principles of the present invention, even for the shot regions which the first alignment sensor (8XA) is incapable of detecting the relative deviation of alignment marks from given fiducial positions, the position of the shot region can be detected based on the matrix data measured by the second alignment sensor (13). In addition, based on the matrix data detected by the alignment sensor (13), the scaling of a wafer (W) can be obtained to improve overlaying accuracy.

In this case, among a plurality of shot regions on the substrate (W), for those whose alignment marks cannot be detected by the first alignment sensor (8XA), the detected results from the second alignment sensor (13) may be statistically analyzed to obtain the matrix data obtained for the use of alignment (step 108). By doing so, even with existence of shot regions whose alignment marks (12XA) are damaged or missed on the peripheries of the substrate (W) during processing, an accurate alignment can be performed based on the matrix coordinates obtained by the second alignment sensor (13).

When aligning the mask (R) and each of the shot regions on a substrate (W), the detected results from the second alignment sensor (13) may be statistically analyzed to obtain the expansion rate of the matrix for a plurality of the shot regions on the substrate, and the magnification rate of the projected image of the mask (R) via the projection optical system (PL) may be adjusted according to the expansion rate of the matrix (step 104). This improves overlying accuracy because the magnification rate of the projection optical system (PL) can be adjusted according to the expansion rate (wafer scaling) of the shot matrix.

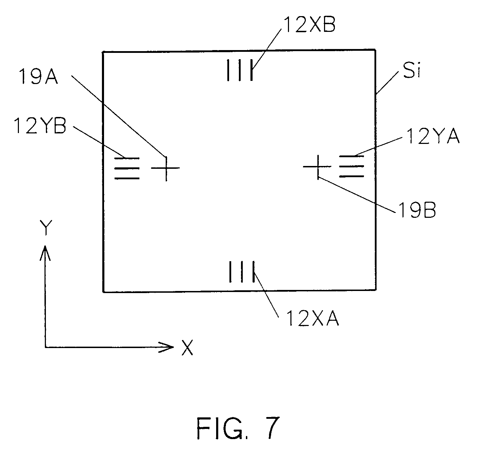

Also as shown in Figure 7, a plurality of alignment marks (19A, 19B) on the substrate (W) may be used as global alignment marks. The results of the measurement taken by the second alignment sensor (13) may be statistically analyzed to obtain the expansion rate of the pattern within a plurality of the shot regions on the substrate (W). When aligning the mask (R) and each of the shot regions on the substrate (W), the magnification rate of the projected image of the mask pattern via the projection optical system (PL) may be adjusted according to the expansion rate of the pattern.

Using the second alignment sensor (13), the average expansion rate (chip scaling) can be obtained for chip patterns in each of the shot regions such that the projection magnification of the projection optical system (PL) can be adjusted according to the expansion rate.

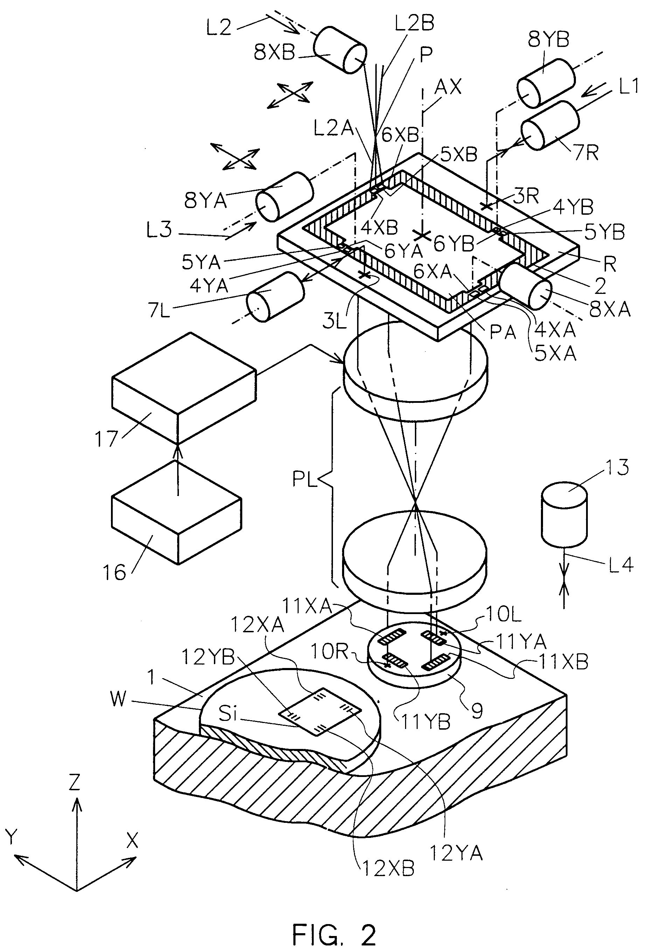

In the second exposure method incorporating the principles of the present invention, as shown in Figures 2, 3, and 8, for example, when a pattern on a mask (R) to be transferred to a plurality of shot regions is sequentially superimposingly photoprinted onto a photosensitive substrate (W) via the projection optical system (PL), the mask (R) and the substrate (W) are aligned via the die-by-die method using:
a first alignment sensor (8XA) which detects relative deviation of alignment marks (12XA) from fiducial positions formed in each of the shot regions of the substrate; (W) and
a second alignment sensor which detects a pattern mode formed on the mask (R);
the measurement taken by the first alignment sensor (8XA) and the pattern data obtained by analyzing the measurements taken by the mask alignment sensor (step 121).

According to the second exposure method, the overlaying accuracy is improved by correcting the projected image magnification rate and the like according to the pattern scaling of the mask (R) measured by the mask sensor, and
The subject invention relates to an exposure method in which a pattern on a mask is transferred by exposing onto a plurality of shot regions on a substrate by the alignment of said mask and each of said shot regions on said substrate via the die-by-die method characterized by the steps of:
measuring the relative deviation of alignment marks formed on each of said shot regions of said substrate from given fiducial positions by a first alginment sensor;
detecting a information of positions of global alignment marks formed on each of said shot regions of said substrate by a second alignment sensor;
calculating an arrangement data based on the measurements taken by said second alginment sensor; and
aligning said mask and each of the shot regions on said substrate using said arrangement data and the measurements taken by said first alginment sensor.

The subject invention also covers an exposure apparatus wherein a pattern on a mask is exposed onto a plurality of shot regions on a substrate by the alginment of said mask and each of said shot regions on said substrate via the die-by-die method, said exposure apparatus comprising:
a first alignment sensor arranged above said mask for measuring the relative deviation of alignment marks formed in each of the shot regions of said substrate from given fiducial positions;
a second alignment sensor arranged above said mask for detecting positions of global alignment marks; and
a main controller coupled to said first and second sensors for calculating an alignment data of said shot regions by statically analyzing the measurements taken by said second alginment sensor, whereby said exposure apparatus aligns said mask and each of the shot regions on said substrate, using said alignment data and measurements taken by said alignment sensor.

The subject invention also covers an exposure apparatus for exposing a pattern on a mask onto a plurality of shot regions on a substrate by the alignment of said mask and each of said shot regions on said substrate via the die-by-die method, said exposure apparatus comprising:
a first alignment sensor arranged above said mask for measuring the relative deviation of alignment marks formed in each of the shot regions of said substrate from given fiducial positions;
a mask alignment sensor arranged above said mask for detecting a pattern mode formed on said mask; and
a main controller coupled to said first and mask alignment sensors for obtaining pattern data by analyzing the measurements taken by said mask alignment sensor, whereby said exposure apparatus adjust magnification rate of the image of said mask pattern exposed on said substrate according to the pattern error.

The subject invention also covers an exposure method in which a pattern on a mask is transferred by exposing onto a plurality of shot regions on a substrate by the alignment of said mask and each of said shot regions on said substrate via the die-by die method comprising the steps of:
measuring the relative deviation of alignment marks formed on each of said shot regions of said substrate from given fiducial positions;
detecting a information of positions of global alignment marks formed on each of said shot regions of said substrate;
calculating an alignment parameters based on the information of positions; and
aligning said mask and each of the shot regions on said substrate using said alginment parameters and the relative deviation.

### BRIEF DESCRIPTION OF THE DRAWINGS

The above and other objects, features, and advantages of the present invention will become more apparent from the following detailed description taken with the accompanying drawings, in which:
Figure 1 is a flowchart showing Embodiment 1 of the present invention;
Figure 2 is a schematic layout of the projection exposure apparatus used in the embodiments of the present invention;
Figure 3 is an enlarged plan view showing the matrix of each of the shot regions on the wafer W in Figure 2;
Figure 4 is a flowchart showing Embodiment 2 of the present invention;
Figure 5 is a plan view showing wafer marks used in Embodiment 2 of the present invention;
Figure 6 is a flowchart showing Embodiment 3 of the present invention;
Figure 7 is a plan view showing wafer marks used in Embodiment 3 of the present invention;
Figure 8 is a flowchart showing Embodiment 4 of the present invention; and
Figure 9 is a flowchart showing an example of an exposure method of conventional technology.

### DESCRIPTION OF THE PREFERRED EMBODIMENTS

Referring to the drawings, Embodiment 1 of the exposure method and apparatus incorporating the principles of the present invention is described particularly referring to Figures 1 through 3. This embodiment applies the present invention for alignment and exposure via the die-by die method using a TTR alignment sensor.

Figure 2 shows the main section of the stepper projection exposure apparatus. Using the apparatus of Figure 2, a circuit pattern in the pattern region PA of the reticle R is superimposingly photoprinted, during the exposing operation, in each of the shot regions on the wafer W. The photoprinting is carried out with a projection magnification β (e.g., β = 1/5) via the projection optical system PL under exposing light (wavelength λ1) from the illumination optical system not illustrated. Embodiment 1 is described herein taking the Z-axis in parallel with the optical axis AX of the projection optical system PL; the X-axis and the Y-axis in a plane perpendicular to the Z-axis.

A reticle R is held on a reticle stage not illustrated. A reticle stage aligns the reticle R in the X-, Y-, and rotational directions. On the other hand, the wafer W is held on a wafer stage 1, which aligns the wafer W in the X-, Y-, Z-, and rotational directions and the like. These stages are not illustrated since they are conventional and to avoid unnecessarily complicating the drawing.

When exposure on a shot region on the wafer W is complete, the wafer stage moves in the stepping operation and the next shot region is set in the exposure field of the projection optical system PL. Then alignment and exposure takes place. In the same manner, each of the shot regions on the wafer W are exposed in the step-and-repeat method.

Also the projection optical system PL has a built-in imaging property controller not illustrated for micro-adjusting a given lens location and inclined angle to correct imaging properties such as projection magnification rate or distortion. This imaging property controller is controlled by the imaging property controller 17, which in turn is controlled by a main controller 16 which governs the apparatus. The main controller 16 is supplied with data such as environmental data from temperature sensors, atmospheric pressure sensors, or measurements on the exposure light intensity, and scaling state of reticle R. Based on this data, the main controller 16 corrects imaging properties of the projection optical system PL via the imaging property controller 17.

Next, the alignment marks and various alignment sensors used in the method incorporating the principles of the present invention are described herein. First, two crisscross alignment marks 3R and 3L are arranged opposite the field of view of the projection optical system PL outside a light shield 2 surrounding the pattern area PA of the reticle R. TTR reticle alignment microscopes 7R, 7L are respectively arranged above the alignment marks 3R, 3L via mirrors which bend the illumination light such that they use the illumination light L1 of the same wavelength λ as the exposure light.

In the vicinity of wafer W on the wafer stage 1 is fixed a fiducial mark member 9. Two fiducial marks 10R, 10L are formed opposite the surface of the fiducial mark member 9 along the X-direction. A laser interferometer is attached for measuring positions in the X-direction and two laser interferometers are attached for measuring positions in the Y-direction on the wafer stage 1 of Figure 2. The X-coordinate and Y-coordinate of the wafer stage 1 is calculated based on the measurements taken by these laser interferometers with about 0.01 µm resolution. Again, these conventional interferometers are not illustrated to avoid unnecessarily complicating the drawing.

In addition, the yawing of the wafer stage 1 is calculated based on the difference in measurements taken by the two laser interferometers for measuring positions on the Y-axis. The coordinates (X, Y) of the wafer stage 1 obtained by calculation based on the measurements taken by the laser interferometers are called the coordinates in the stage coordinate system. In this case, the X-axis in the stage coordinate system of this embodiment is set, for example, in parallel with a straight line which goes through the fiducial marks 10R, 10L on the surface of the fiducial mark member 9.

Between the fiducial marks 10R, 10L on the surface of the fiducial mark member 9, a pair of fiducial marks 11XA, 11XB are formed at a given pitch in the X-axial direction as a diffraction grating. Also, a pair of fiducial marks 11YA, 11YB are formed at a given pitch in the Y-axial direction as a diffraction grating.

The surface of the fiducial mark member 9 is arranged in conjugation with the pattern of the reticle R with respect to the projection optical system PL under exposure light. When aligning the reticle R, the fiducial marks 10R, 10L on the wafer stage can be conjugated with the alignment marks 3R, 3L of the reticle R by driving the wafer stage 1. In this case, the reticle alignment microscopes 7R, 7L illuminate the alignment marks 3R, 3L and the fiducial marks 10R, 10L together with illumination light L1 of the same wavelength λ1 as that of the exposure light. Each of the images of the alignment marks 3R, 3L and the fiducial marks 10R, 10L are formed on the image pick-up device in the reticle alignment microscopes 7R, 7L. The positional deviation in the X- and Y-direction of the alignment marks 3R, 3L from the fiducial marks 10R, 10L is detected by processing the image pick-up signals from these image pick-up devices.

These alignment marks 3R, 3L of the reticle R are always fixed at a given position even on the reticles having pattern areas PA of different sizes. They are set such that the mirror on top of the reticle alignment microscopes 7R, 7L does not shield the exposure light which uniformly illuminates the pattern areas PA during exposure.

In addition, at the edge of the light shield 2 which encloses the pattern area PA of the reticle R at the edge pointing toward the +Y-direction, the reticle marks 4XB, 5XB, and a window 6XB in the diffraction grating are arranged at a given distance in the Y-direction (in the direction not measured). At the edge pointing toward the -Y-direction, the reticle marks 4XA, 5XA, and a window 6XA are arranged at a given distance in the Y-direction. At the edge of the light shield 2 pointing toward the -X-direction, the reticle marks 4YA, 5YA, and a window 6YA are arranged at a given distance in the X-direction. At the edge pointing toward the +X-direction, the reticle marks 4YB, 5YB, and a window 6YB are arranged at a given distance in the X-direction. Accordingly, in each of the shot regions Si on the wafer W, the wafer marks 12XB, 12XA are formed in the X-axial direction and the wafer marks 12YA, 12YB are formed in the Y-axial direction.

An X-axial TTR reticle alignment sensor 8XB for measuring points is arranged above the reticle marks 4XB, 5XB, and the window 6XB via a mirror which bends the optical path. Another X-axial TTR reticle sensor 8XA is arranged above the reticle marks 4XA, 5XA, and window 6XA. A Y-axial TTR alignment sensor 8YA is arranged above the reticle marks 4YA, 5YA, and window 6YA via a mirror which bends the optical path. Another Y-axial TTR alignment sensor 8YB is arranged above the reticle marks 4YB, 5YB, and window 6YB. The TTR alignment sensors 8XB, 8XA, and 8YA, 8YB are sensors which detect the positional deviation of the reticle mark and a wafer mark via the LIA method using illumination light L2 and L3 of wavelength λ2.

In other words, one of the X-axial TTR alignment sensors 8XB generates a pair of alignment light beams L2A, L2B of slightly different frequency from the illumination light L2 which light beams are capable of interfering and intersect at the position P shown above the reticle R. During alignment operation of the wafer W, these alignment light beams L2A, L2B are used to detect the positional deviation of the reticle marks 4XB, 5XB from the wafer marks 12XB in the X-direction. The other alignment sensor 8XA is used to detect the positional deviation of the reticle marks 4XA, 5XA from the wafer marks 12XA in the X-direction. In the same manner, one of the Y-axial TTR alignment sensors 8YA generates a pair of alignment light beams of slightly different frequency from the illumination light L3. These alignment light beams are used to detect the positional deviation of the reticle marks 4YA, 5YA from the wafer marks 12YA in the Y-direction. The other alignment sensor 8YB is used to detect the positional deviation of the reticle marks 4YB, 5YB from the wafer marks 12YB in the Y-direction.

In addition, when the reticle mark positions change according to the sizes of the pattern areas PA of the reticle R, the TTR alignment sensors 8XB, 8XA, and 8YA, 8YB are movably supported in each of the X- and Y-directions. Also, the fiducial mark 11XB is formed wide enough to cover the moving range of the reticle marks 4XB, 5XB on the fiducial mark member 9. In the same manner, other fiducial marks 11XA, 11YA, 11YB are also formed wide enough to cover the moving range of their respective reticle marks.

In summary, in this embodiment, the binocular 4-axial reticle alignment microscopes 7R, 7L and the 4-eye four-axial TTR alignment sensors 8XB, 8XA, 8YA, 8YB are formed for measuring the alignment marks on the reticle R.

In this embodiment, the fiducial mark member 9 is aligned within the exposure field of the projection optical system PL to detect alignment marks 3R, 3L and fiducial marks 10R, 10L by the reticle alignment microscopes 7R, 7L and to detect the positional deviation of each of the reticle marks and their corresponding fiducial marks simultaneously by the TTR alignment sensors 8XB, 8XA and 8YA, 8YB. Based on the results of the detection, the target value (a kind of a baseline) for the positional deviation for the values detected by the TTR alignment sensors 8XB, 8XA, 8YA, and 8YB can be obtained.

Furthermore, the projection exposure apparatus of this embodiment has an off-axial FIA alignment sensor 13 (hereafter referred to as the "FIA alignment sensor"). The search alignment of the wafer W and detection of the wafer mark position for a sample shot for the EGA alignment described later is performed via an image processing method using this FIA alignment sensor 13. Also, the baseline, which is the positional deviation of the detection center of the FIA alignment sensor 13 from the exposure center, is obtained using the fiducial marks 11YA, 11XA, etc. on the fiducial mark member 9.

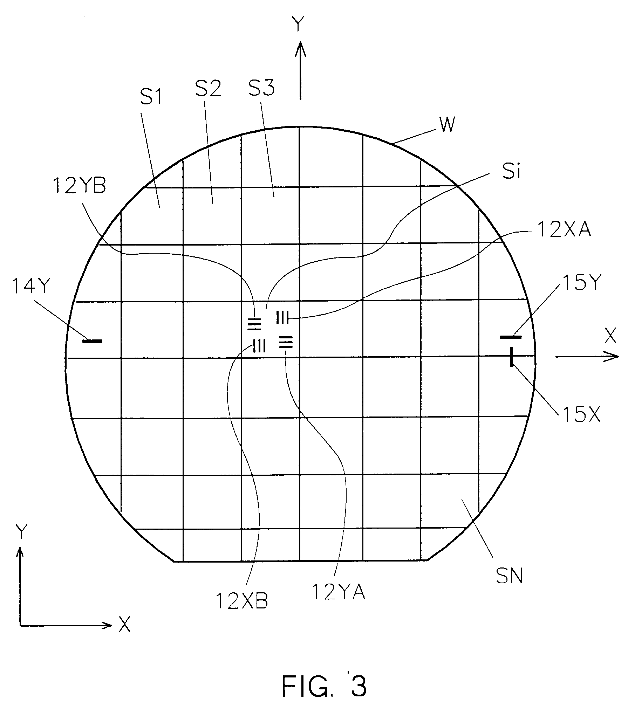

Figure 3 shows the shot matrix on the wafer W of this embodiment. In Figure 3, n shot regions S1, S2, S3,..., SN are arranged at a given pitch along the x-axis and y-axis in the sample coordinate system set on the wafer W. Two search marks 14Y, 15Y for measuring positions on the Y-axis are formed for search alignment in the vicinity of both ends of the wafer W in the X-direction. An X-axial search mark 15X is formed in the vicinity of the Y-axial search mark 15Y at the edge of the wafer W in the +X-direction. As described, two X-axial wafer marks 12XA, 12XB and two Y-axial wafer marks 12YA, 12YB are formed for measuring positions on the X-axis and Y-axis respectively in the shot region Si on wafer W. Four wafer marks are formed in the same manner for each of the other shot regions.

Referring again to Figure 2, the FIA alignment sensor 13 emits illumination light L4 with a different wavelength from the exposure light, for example, onto the wafer mark 12XA on wafer W. The detection light from the wafer mark 12XA returns via the optical path to form an image of the wafer mark 12XA on the indication plate which is built into the FIA alignment sensor 13. An indication mark is formed on the indication plate. The detection light transmits images of two marks onto the image pick-up device, such as two-dimension CCD, etc., which is built into the FIA alignment sensor 13. These images of the two marks are processed. The deviation between the two marks is calculated and the position of the wafer stage 1 is added to the results to obtain the X-coordinate of the wafer mark 12XA. Positions of other wafer marks 12XB, 12YA, 12YB in the shot region Si can also be calculated in the same manner.

During the search alignment of a wafer W, measurements are taken for the positions of two Y-axial search marks 14Y, 15Y and the X-axial search mark 15X by the FIA alignment sensor 13. The coordinate position of the wafer W in the Y-direction is obtained by averaging the measurements taken for the Y-coordinate of the two Y-axial search marks 14Y, 15Y. The coordinate position of the wafer W in the X-direction is obtained based on the measurements taken for the X-axial search mark 15X. Also, the yawing on the XY-plane of the wafer W can be obtained based on the measurements taken for the positions for the two Y-axial search marks 14Y, 15Y. Note that when measuring the baseline for the FIA alignment sensor 13, the fiducial mark member 9 is moved to the measuring position in the alignment sensor 13. The FIA alignment sensor 13 measures positions of the fiducial marks 11XA, 11XB, 11YA, and 11YB on the fiducial mark member 9.

Next, the operation in which alignment and exposure is performed in the projection exposure apparatus of this embodiment is described referring to the flowchart in Figure 1. This embodiment shows a preferable exposure method which may be used when some wafer marks in the target shot region are damaged during processing and the like or when some wafer marks are missing in the shot regions on the peripheries of the wafer W. It is assumed that, prior to exposure, a target value (baseline for the TTR alignment sensor 8XA, 8XB, 8YA, and 8YB and that for the FIA alignment sensor 13) is obtained. Note that the method is described referring to the measurements taken by the TTR alignment sensor 8XB, however, other measurements taken by the three-axis TTR alignment sensors 8XA, 8YA, 8YB may be used in the same manner.

Figure 1 shows a flowchart to describe the exposure method of this embodiment. As shown in Figure 1, first in step 101, a wafer (wafer W) is loaded onto a wafer stage 1. In step 102, a search alignment is performed by the FIA alignment sensor 13 shown in Figure 2. In other words, offsets from the origin of the sample coordinates (x, y) in the X- and Y-directions and yawing of sample coordinate system (x, y) are detected in the sample coordinate system on the wafer W. Rough matrix coordinates in the stage coordinate system (X, Y) regions, which define the position for the wafer stage 1 to be moved, are calculated for each of the shot regions based on the detection results and the designed matrix coordinates in the sample coordinate system (x, y) for each of the shot regions on the wafer W. In this way, the global alignment is the operation in which a rough coordinate position is calculated for each of the shot regions on the wafer.

Next, in step 103, the enhanced global alignment (hereafter referred to as "EGA") disclosed in Japanese patent Kokai S61-44429, corresponding to U.S. patent No. 4,677,301 for example, is performed. In other words, n (n is an integer equal to or greater than 3) shot regions are selected for samples among N shot regions S1, S2, S3,..., SN as shown in Figure 3. The X-coordinate for the wafer mark 12XA and the Y-coordinate for the wafer mark 12YA are measured within the sample shot regions using the FIA alignment sensor 13 shown in Figure 2.

For example, about 5 to 10 shot regions are selected as samples in the wafer W. With the results of the above measurements and the designed matrix coordinates In the sample coordinate system (x, y) in which wafer marks are positioned in each of the shot regions, six transformation parameters (EGA parameters) consisting of scaling (linear expansion) factors αx, αy in the X- and Y-directions of the shot matrix on the wafer, yawing θw, orthogonality, and offsets in the X- and Y-directions are calculated by the least square method. Thus, using these six transformation parameters and designed matrix coordinates for each of the shot regions on the wafer W, the matrix coordinates on the stage coordinate system (X, Y) are calculated for each of the shot regions. The controller 16 performs the sequence of calculations and the resulting parameters and matrix coordinates are stored in the main controller 16.

In step 104, the projection optical system PL is adjusted. As described above, six transformation parameters consisting of scaling (linear expansion) factors αx, αy in the X- and Y-directions of the shot matrix on the wafer, yawing θw, orthogonality, and offsets in the X- and Y-directions are calculated via the EGA alignment method in step 103. In this embodiment, the main controller 16 corrects the projection magnification rate β of the projection optical system through the imaging property controller 17 which controls the imaging properties of the projection optical system PL. This operation improves overlaying accuracy.

In the next step 105, the wafer stage 1 is driven according to the matrix coordinates obtained in the aforementioned EGA alignment method to shift the target shot region (shot region Si) to the exposure field of the projection optical system PL. In this case, the wafer stage 1 may be shifted to the target shot region based on the coordinates calculated in the global alignment method in step 102. Then, the TTR reticle alignment sensor 8XB emits the illumination light L2 to the reticle marks 4XB, 5XB and the wafer mark 12XB to measure the intensity of the signals detected by photoelectrically converting interference light from each of the marks.

In step 106, the intensity of the signal is detected by comparing intensities of signals to tell whether or not the wafer mark 12XB is normal, damaged, or missing. When the intensity of the signal detected from the wafer mark 12XB is less than a predetermined value, the wafer mark 12XB is considered to be damaged or missing. Then the sequence goes to step 108, in which the final alignment is performed based on the coordinate positions of the shot region Si obtained in step 103 through the EGA alignment method. Then, the sequence goes to step 109.

On the other hand, when the intensity of the signal detected from the wafer mark 12XB is equal to or greater than a given value, the signal is considered to be normal. Then the sequence goes to step 107, in which the die-by-die (D/D) alignment is performed and the mark is exposed. In step 109, whether or not all the shot regions on the wafer W are exposed is checked. If there is any shot region left unexposed, the sequence returns to step 105. Then steps 105 through 109 are repeated until all shot regions are exposed. When the fact that all shot regions are exposed is confirmed, whether or not all wafers are exposed is checked in step 110. Then steps 101 through 110 are repeated until all wafers W are exposed.

As mentioned, according to the exposure method incorporating the principles of the present invention, alignment and exposure operation can be performed based on the results of the EGA alignment calculation regardless of the fact that some wafer marks are missing in the shot regions on the peripheries of a wafer or a wafer is damaged during processing. Also in this embodiment, the wafer marks, 12XA, 12YA, for the TTR alignment sensor are used as alignment marks for the FIA alignment sensor 13. This eliminates the need for any independent FIA alignment marks and increases efficiency. Note that in step 106, not only is the intensity of signals from the wafer marks compared, but also wafer marks whose measured position deviates from a predetermined tolerable position of the coordinates are obtained by calculation in the EGA method. This prevents occurrence of alignment errors when a part of the wafer mark positions deviates due to unfavorable factors.

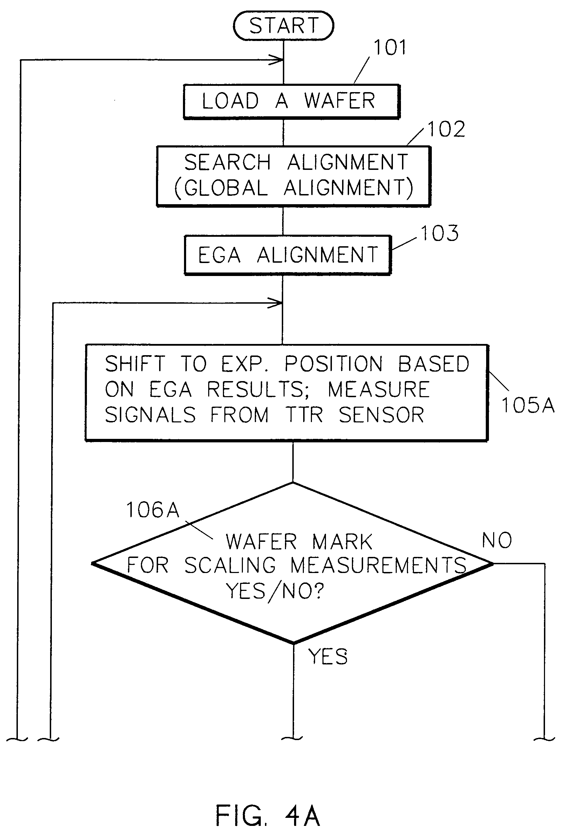

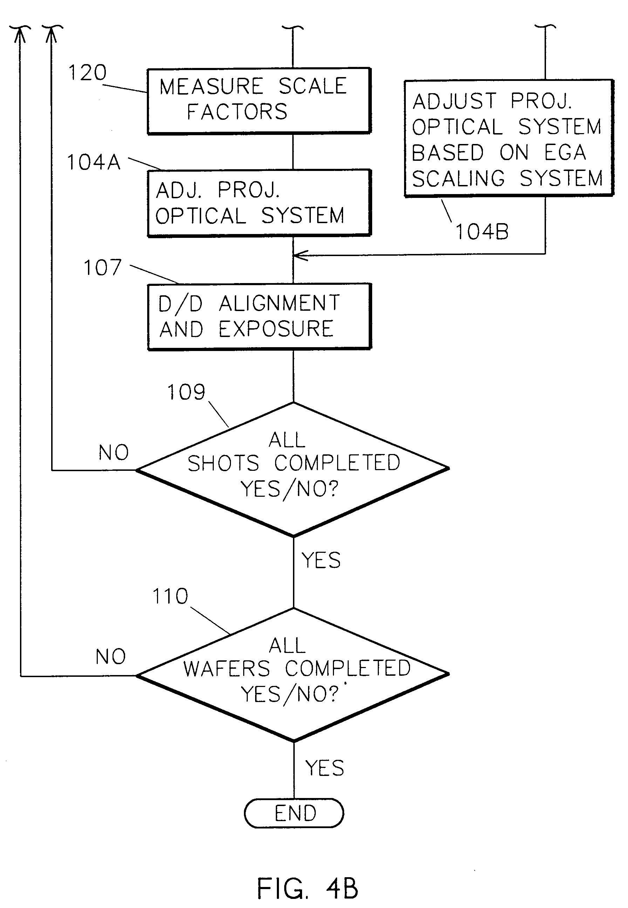

Next, Embodiment 2 of the exposure method of the present invention is described referring to Figure 4. This embodiment is the same as that shown in Figure 1 in that the TTR alignment sensor performs the D/D alignment and exposure and that the matrix coordinates are calculated for each of the shot regions on the wafer W via the EGA alignment method. This embodiment advances the process further and measures two wafer marks formed in the target shot regions by the TTR alignment sensor to calculate the scaling (linear expansion) factors for chip patterns in the shot regions. The imaging properties of the projection optical system PL are based on these scaling factors. If the TTR alignment sensor is not able to detect wafer marks, the imaging properties of the projection optical system PL is corrected based on the level of scaling calculated in the EGA alignment method.

Note that the projection exposure apparatus of this embodiment is basically the same as that used in Embodiment 1 as described in the flowchart of Figure 1, except for the arrangement of the wafer alignment marks and the TTR alignment sensors 8XA, 8XB, 8YA, 8YB. The projection exposure apparatus is described herein referring to Figure 2. The exposure method is also basically the same as described in the flowchart of Figure 1. In Figure 4, the steps that are the same as those of Figure 1 are identified by the same numerals. Details of the flowchart , therefore, will not be described.

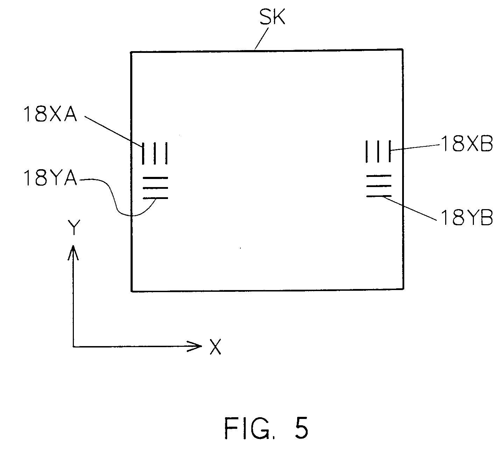

Figure 4 shows the flowchart of the exposure method of this second embodiment. As shown in Figure 4, step 101, the wafer loading, through step 103, EGA alignment, are the same as shown in Figure 1. Note that because the wafer marks formed in the shot regions on the wafer W are different from those shown in Figure 1, this embodiment will be described referring to Figure 5.

Figure 5 is a plan view of the shot regions of the wafer W and shows the status of the wafer marks formed in each of the shot regions. As shown in Figure 5, in the middle of the edge in the X-direction in the shot region SK, the X-axial wafer mark 18XA and the Y-axial wafer mark 18YA are formed adjacent to each other. In the same manner, in the middle of the edge in the +X-direction in the shot region SK, the X-axial wafer mark 18XB and the Y-axial wafer mark 18YB are formed adjacent to each other. All of these wafer marks, 18XA, 18XB, 18YA, 18YB are diffraction grating marks.

The arrangement of the X-axial and the Y-axial reticle marks (not illustrated) corresponds to that of the wafer marks. Therefore, the four-axial TTR alignment sensors 8XA, 8XB, 8YA, and 8YB, which detect each of the deviations of the reticle marks from corresponding wafer marks 18XA, 18XB, 18YA, and 18YB, are arranged to correspond to each other. In other words, the four-axial TTR alignment sensors 18XA, 18XB, 18YA, and 18YB can detect the positional deviation of reticle marks from corresponding wafer marks simultaneously. Also in this embodiment, the TTR alignment sensor detects positional deviation of the two X-axial wafer marks 18XA, 18XB. The (isotropic) scaling of chip patterns in each of the shot regions is obtained based on this deviation. For this reason, the wafer marks 18XA, 18XB are called "scaling measurement wafer marks."

Referring again to Figure 4, in step 103, the FIA alignment sensor 13 measures the wafer mark coordinates, each of which consists of the X-axis and the Y-axis, for the wafer marks 18XA, 18XB, 18YA, and 18YB within a predetermined number of sample shots on a wafer. The results of measurement are statistically analyzed in the EGA alignment technique and six transformation parameters which consist of the scaling (linear expansion) factors αx, αy in the x- and the y-directions in the shot matrix on the wafer W, yawing θw, orthogonality and offsets in the X- and the Y-directions are calculated. Based on the results, the matrix coordinates of all shot regions on the wafer W are calculated.

In step 105A, the target shot region (shot region SK) is shifted to the exposure field by driving the wafer stage based on the matrix coordinates calculated in the EGA alignment method in step 103. Detection signals are input for each of the marks such that the TTR alignment sensors 8XA, 8XB, 8YA, and 8YB can detect the positional deviation of reticle marks from the X-axial wafer marks 18XA, 18XB and the Y-axial wafer marks 18YA, 18YB. If there is any damage or loss in wafer marks 18XA, 18XB, 18YA, or 18YB, the intensity of the detection signal from the wafer mark will be less than a predetermined level. In step 106A, whether or not the intensity of the detection signal obtained from both wafer marks 18XA, 18XB for scaling measurement is above the predetermined level is checked. Note that the object of this embodiment is to correct scaling factors. Therefore, attention is paid to the wafer marks for scaling measurement. If any wafer marks for other factors are missing, one can follow the procedure of Embodiment 1. If the intensity of the detection signal obtained from the wafer marks 18XA, 18XB, 18YA, and 18YB is equal to or larger than the predetermined level, the sequence moves to step 120.

In step 120, the TTR alignment sensor 8XA first measures the positional deviation of the reticle mark from the wafer mark 18XA; then the TTR alignment sensor 8XB measures the positional deviation of the reticle mark from the wafer mark 18XB. The scaling (linear expansion) factor in the X-direction of the shot region SK is calculated based on these two positional deviations. Note that the scaling of the shot region SK is assumed to be isotropic in the X- and the Y-directions.

Next, in step 104A, the controller 16 in Figure 2 corrects the projection magnification rate β of the projection optical lens system PL via the imaging property controller 17 based on the scaling factor calculated in step 120. The D/D alignment and exposure operations are performed in step 107. On the other hand, in step 106A, if the intensity of the signal from at least one of the wafer marks 18XA, 18XB is not equal to or larger than a predetermined level, the sequence moves to step 104B, in which the projection magnification rate β of the projection optical system PL is adjusted based on the scaling factors αx, αy calculated in the EGA alignment method shown in step 103. Then the sequence moves to step 107. The following steps are the same as shown in Figure 1. If other wafer marks besides the above are identified to be missing in step 106A, the final alignment can be performed based on the matrix coordinates calculated in the EGA method.

In summary, this embodiment improves overlaying accuracy because the TTR alignment sensors 8XA, 8XB measure the scaling factors in each of the shot regions via the die-by-die method and the projection magnification rate is corrected based on the scaling measurement. Also, even if there is some damage or loss in wafer marks for the scaling measurement, this embodiment can provide highly accurate superimposed photoprinting of a pattern on a reticle R in those shot regions whose scaling factors cannot be measured on the wafer W because the projection magnification rate of the projection optical system PL is adjusted based on the scaling factors calculated in the EGA alignment method shown in step 103.

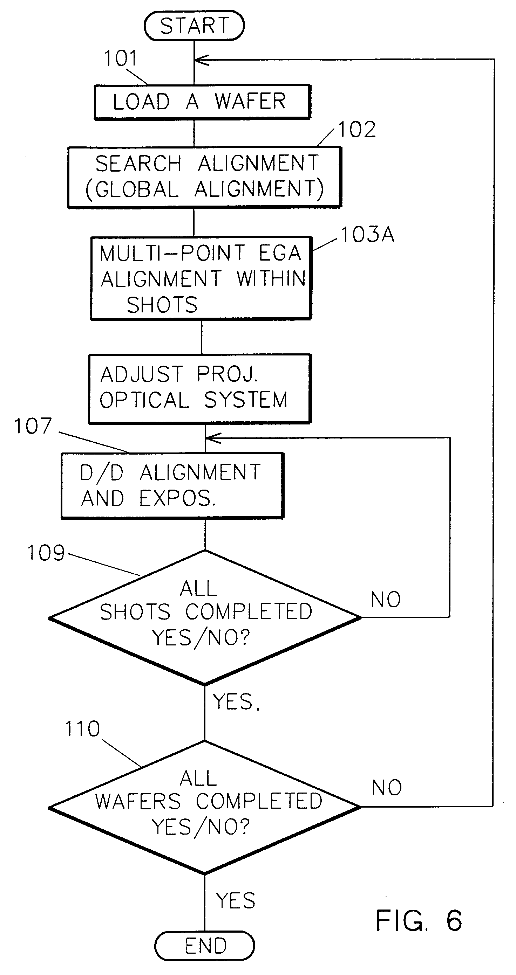

Next, Embodiment 3 of the exposure method incorporating the principles of the present invention is described referring to Figure 6. In this embodiment, a plurality of wafer mark positions are detected using the so-called "EGA alignment method for multi-points in shots." In this method, marks are converted into two-dimensional marks, instead of using the normal EGA alignment method. Note that the projection exposure apparatus used in this embodiment is the same as that used in Embodiment 1. The projection exposure apparatus of this embodiment will be described referring to Figure 2. The exposure method used in this embodiment is also basically the same as that shown in the flowchart of Figure 1. The steps shown in Figure 6 that are the same as those described in Figure 1 are identified by the same numeral and are not described in detail.

Figure 6 is a flowchart which describes the exposure method of this embodiment. In Figure 6, steps are the same as those in Embodiment 1 up through step 102, in which the search alignment is performed. Then, in step 103A, the FIA alignment sensor 13 of Figure 2 measures the FIA alignment mark positions formed in the shot region Si.

Figure 7 is a plan view of the shot regions of the wafer W of this embodiment. In the shot region Si in Figure 7, crisscross alignment marks (hereafter referred to as "FIA alignment marks") 19A, 19B are formed to be measured by the FIA alignment sensor 13 in addition to the wafer marks 12XA, 12XB, 12YA, and 12YB for detection by the TTR alignment sensor. These FIA alignment marks 19A, 19B consist of crisscross marks and are formed in the middle of each end in the X-direction of the shot region Si.

The FIA alignment marks 19A and 19B are formed in all shot regions on the wafer W. In step 103A of Figure 6, the FIA alignment sensor 13 measures the position of the FIA alignment marks 19A, 19B formed on a plurality of sample shots on the wafer W. The matrix coordinates for all shot regions on the wafer W are calculated using the so-called "EGA alignment method for multi-points in shots" together with the average X-axial scaling of chip patterns in all shot regions.

In this Embodiment 3, scaling is considered to be isotropic in the X- and the Y-directions as it is in Embodiment 2. Therefore only the X-axial scaling is measured. The main controller 16 performs these calculation sequences to feed the data to the imaging property controller 17. In step 104, the projection magnification rate β of the projection optical system PL is adjusted based on feedback via the imaging property controller 17. In step 107, the D/D alignment and exposure operations are performed. The steps after this are the same as those in Figure 1.

As described, this embodiment improves overlaying accuracy because the projection magnification rate of the projection optical system PL is corrected based on scaling factors calculated in the EGA alignment method for multi-point in shots.

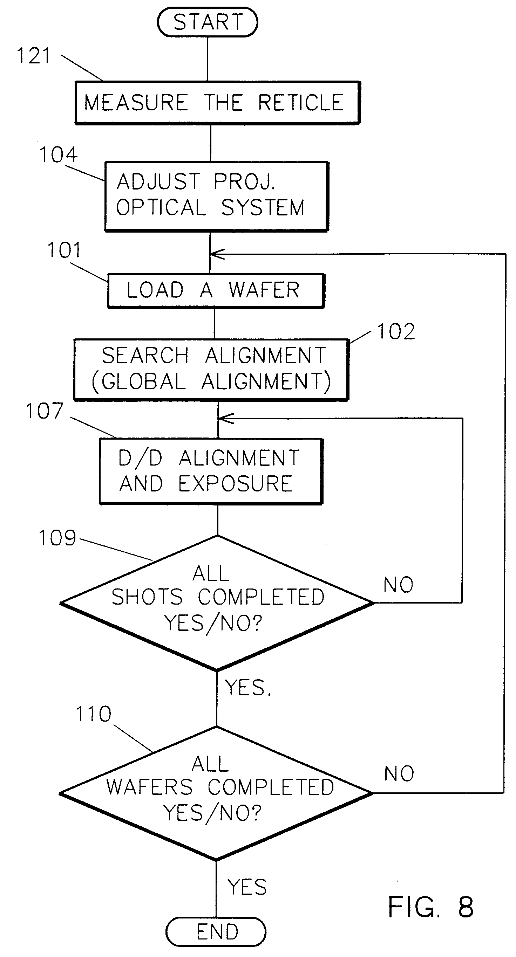

Next, Embodiment 4 of the exposure method of the present invention is described referring to Figure 8. In this embodiment, the TTR alignment sensor 13 adjusts the projection magnification rate of the projection optical system PL based on the magnification error (drawing error) of the original pattern in the die-by-die exposing method. Note that the projection exposure apparatus shown in Figure 2 is used in this embodiment. The process steps are also basically the same as those in Embodiment 1. The same steps as those in Figure 1 are identified in the same manner as in Figure 8 and are not described in detail.

Figure 8 is a flowchart which describes another exposure method incorporating the principles of the present invention. First, in step 121, the magnification error of the original reticle pattern is measured. The reticle alignment microscopes 7L, 7R are used, for example, to observe the two crisscross evaluation marks (not illustrated) formed on the pattern area on the reticle R and its corresponding fiducial marks (not illustrated) on the fiducial mark member 9 on the wafer stage 1 such that the positional deviation of the distance between the two evaluation marks on the reticle R from the designed value can be measured. The magnification error of the reticle R is calculated based on this measured positional deviation.

In step 104, the projection magnification rate β of the projection optical system PL is adjusted based on the magnification error of the pattern on the reticle R obtained through the above calculation. Then, in step 101, the wafer W is loaded. In step 102, the search alignment and the global alignment are performed. In step 107, the D/D alignment and exposure are performed. Steps after these are the same as those in Embodiment 1.

This embodiment improves overlaying accuracy because the reticle alignment microscopes 7L, 7R obtain the magnification error of the pattern on the reticle R and the image properties of the projection optical system are adjusted based on the results.

Note that in the above embodiment, the FIA alignment sensor 13 is used, as shown in Figure 2, for the search alignment and the global alignment. However, a laser beam may be emitted onto the dot-like alignment marks on a wafer to have the LSA alignment sensor detect the mark positions using the diffraction or scattering of light.

The methods incorporating the principles of present invention are not limited to the batch-type projection exposure apparatus such as steppers. It may be applied to scan exposure type such as the step-and-scan exposure apparatus, in which a part of a reticle pattern is projected onto a wafer. The reticle and wafer are synchronously scanned through an exposure field of a projection optical system to sequentially photoprint the reticle pattern onto shot regions on a wafer.

The first exposure method incorporating the principles of the present invention can provide highly accurate alignment because, even when the first alignment sensor cannot detect the positional deviation of the alignment marks in the shot region or, for example, when the intensity of the signal detected by the first alignment sensor is weak, the second alignment sensor can provide the matrix data based on its detection results.

When the first alignment sensor cannot detect alignment mark positions in a plurality of shot regions on a substrate, the second alignment sensor can use the matrix data obtained by statistically analyzing measurement results. In this way, even when some alignment marks are damaged during processing or some alignment marks are missing in some shot regions, a mask can be aligned highly accurately using the matrix coordinates obtained by the second alignment sensor.

When a mask and each of the shot regions on the substrate are aligned by statistically analyzing the results of the measurements taken by the second alignment sensor to obtain the scaling factors of the matrix for a plurality of shot regions on a substrate, the overlaying accuracy can be improved if the magnification rate of the projected mask pattern image through the projection optical system is adjusted according to the matrix scaling. This is because the magnification rate of the projection optical system is adjusted according to the shot region scaling.

For the global alignment mark on the substrate, a plurality of alignment marks formed in each of the shot regions on a substrate may be used to statistically analyze the results of measurements taken by the second alignment sensor to obtain the scaling of patterns in a plurality of shot regions for aligning a mask and each of the shot regions on a substrate. The overlaying accuracy can be improved even more if the magnification rate of the projected pattern image is adjusted according to the pattern scaling because the projection magnification rate of the projection optical system is adjusted according to the average scaling of chip patterns in shot regions such that the magnification error due to chip pattern scaling which occurs in the shot regions are corrected.

The second exposure method incorporating the principles of the present invention can provide highly accurate alignment according to the mask pattern state measured by the second alignment sensor by correcting the projection magnification rate and the like.

Various modifications will become possible for those skilled in the art after receiving the teachings of the present disclosure without departing from the scope thereof.

## Claims

1. An exposure method in which a pattern on a mask is transferred by exposing the mask pattern onto a plurality of shot regions on a substrate by the alignment of said mask and each of said shot regions on said substrate via the die-by-die method characterized by the steps of:
measuring the relative deviation of alignment marks formed on each of said shot regions of said substrate from given fiducial positions by a first alignment sensor;
detecting information positions of global alignment marks formed on each of said shot regions of said substrate by a second alignment sensor;
calculating arrangement data based on the measurements taken by said second alignment sensor; and
aligning said mask and each of the shot regions on said substrate using said arrangement data and the measurements taken by said first alignment sensor.

2. An exposure method, as claimed in claim 1, wherein alignment is performed for a shot region using only the arrangement data whenever said first alignment sensor is not able to detect the positions of alignment marks on said shot region.

3. An exposure method, as claimed in claim 1 or 2, wherein measurements taken by said second alignment sensor are statistically analyzed to obtain scaling factors of patterns within said plurality of shot regions on said substrate, and wherein when aligning said mask and each of said shot regions on said substrate, the magnification rate of the image of said mask pattern exposed on said substrate is adjusted according to the scaling factors.

4. An exposure method, as claimed in Claim 1 or 2, wherein a plurality of alignment marks formed within each of the shot regions are used as marks for global alignment on said substrate, the measurements taken by said second alignment sensor are statistically analyzed to obtain scaling factors of patterns within a plurality of shot regions on said substrate, and wherein when aligning said mask and each of the shot regions on said substrate, the magnification rate of the image of said mask pattern exposed on said substrate is adjusted according to the scaling factors of said patterns.

5. An exposure method, as claimed in claims 3 or 4, further characterized by the steps of:
detecting a pattern mode formed on said mask by a mask alignment sensor; and
adjusting said magnification rate according to the pattern mode.

6. An exposure apparatus for exposing a pattern on a mask onto a plurality of shot regions on a substrate by the alignment of said mask and each of said shot regions on said substrate via the die-by-die method, said exposure apparatus being characterized by:
a first alignment sensor arranged above said mask for measuring the relative deviation of alignment marks formed in each of the shot regions of said substrate from given fiducial positions;
a second alignment sensor arranged above said mask for detecting positions of global alignment marks; and
a main controller coupled to said first and second sensors for calculating an alignment data of said shot regions by statically analyzing the measurements taken by said second alignment sensor, whereby said exposure apparatus aligns said mask and each of the shot regions on said substrate, using said alignment data and measurements taken by said first alignment sensor.

7. An exposure apparatus for exposing a pattern on a mask onto a plurality of shot regions on a substrate by the alignment of said mask and each of said shot regions on said substrate via the die-by-die method, said exposure apparatus characterized by:
a first alignment sensor arranged above said mask for measuring the relative deviation of alignment marks formed in each of the shot regions of said substrate from given fiducial positions;
a mask alignment sensor arranged above said mask for detecting a pattern mode formed on said mask; and
a main controller coupled to said first and mask alignment sensors for obtaining pattern data by analyzing the measurements taken by said mask alignment sensor, whereby said exposure apparatus adjust magnification rate of the image of said mask pattern exposed on said substrate according to the pattern error.

8. An exposure method in which a pattern on a mask is transferred by exposing onto a plurality of shot regions on a substrate by the alignment of said mask and each of said shot regions on said substrate via the die-by-die method, characterized by the steps of:
measuring the relative deviation of alignment marks f ormed on each of the shot regions of said substrate from given fiducial positions;
detecting information positions of global alignment marks formed on each of said shot regions of said substrate;
calculating alignment parameters based on the information positions; and
aligning said mask and each of the shot regions on said substrate using said alignment parameters and the relative deviation.

9. An exposure method, as claimed in claim 8, wherein alignment is performed for a shot region using only the alignment parameters whenever said relative deviation is not detected.

10. An exposure method, as claimed in claim 8 or 9, wherein said alignment parameters includes at least scaling factors of patterns within said plurality of shot regions on said substrate, and wherein when aligning said mask and each of said shot regions on said substrate, the magnification rate of the image of said mask pattern exposed on said substrate is adjusted according to the scaling factors.

11. An exposure method, as claimed in 8 or 9, wherein a plurality of alignment marks formed within each of the shot regions are used as marks for global alignment on said substrate, said alignment parameters includes at least scaling factors of patterns within a plurality of shot regions on said substrate, and wherein when aligning said mask and each of said shot regions on said substrate, the magnification rate of the image of said mask pattern exposed on said substrate is adjusted according to the scaling factors of said patterns.

12. An exposure method, as claimed in claim 8 or 9, wherein said alignment parameters are statistically calculated based on the design value and the measurement value and the relative deviation.

13. An exposure method, as claimed in claim 8 or 9 further characterized by:
detecting a pattern error formed on said mask, and adjusting said magnification rate according to the pattern error.

14. An exposure method, as claimed in claim 13, wherein said pattern error includes said pattern scaling.

15. An exposure method, as claimed in claim 1 or 2, wherein said arrangement data are statistically calculated based on the design value and the measurements taken by said second alignment sensor.
